# FASCICULE DE BREVET EUROPEEN

(11) **EP 4 557 384 B1**
(45) Date de publication et mention de la délivrance du brevet: **29.04.2026**
(21) Numéro de dépôt: 24209160.1
(22) Date de dépôt: 28.10.2024
(51) Int. Cl.: H10F 19/40, H10F 71/00, H10K 30/57, H10K 39/10, H10K 39/15, H10K 85/50

(54) **ASSEMBLAGE PHOTOVOLTAÏQUE MULTI JONCTIONS AUTORÉPARABLE ET PROCÉDÉ D'AUTORÉPARATION D'UN TEL ASSEMBLAGE**
SELBSTREPARIERENDE PHOTOVOLTAISCHE MEHRFACHANORDNUNG UND SELBSTREPARATURVERFAHREN EINER SOLCHEN ANORDNUNG
SELF-REPAIRING MULTIJUNCTION PHOTOVOLTAIC ASSEMBLY AND SELF-REPAIR METHOD OF SUCH ASSEMBLY

(30) Priorité: 17.11.2023 FR 2312605
(43) Date de publication de la demande: 21.05.2025
(73) Titulaire: Electricité de France, 75008 Paris (FR)
(72) Inventeur: PUEL, Jean-Baptiste, 75014 PARIS (FR)
(74) Mandataire: Plasseraud IP

(56) Documents cités:
- US-A1- 2018 175 112
- LI ET AL: "Perovskite Tandem Solar Cells: From Fundamentals to Commercial Deployment", CHEMICAL REVIEWS, AMERICAN CHEMICAL SOCIETY, US, vol. 120, no. 18, 7 August 2020 (2020-08-07), pages 9835 - 9950, XP009535771, ISSN: 0009-2665, DOI: 10.1021/ACS.CHEMREV.9B00780
- KHAN FIROZ ET AL: "Perovskite-based tandem solar cells: Device architecture, stability, and economic perspectives", RENEWABLE AND SUSTAINABLE ENERGY REVIEWS, ELSEVIERS SCIENCE, NEW YORK, NY, US, vol. 165, 24 May 2022 (2022-05-24), XP087086845, ISSN: 1364-0321, [retrieved on 20220524], DOI: 10.1016/J.RSER.2022.112553
- FARID YASIR ET AL: "Modeling and Analysis of Novel Tandem Solar Cells", 2019 INTERNATIONAL CONFERENCE ON ELECTRICAL, COMMUNICATION, AND COMPUTER ENGINEERING (ICECCE), IEEE, 24 July 2019 (2019-07-24), pages 1 - 6, XP033678366
- MIME FARHA ISLAM ET AL: "Design and Performance Analysis of Tandem Organic Solar Cells: Effect of Cell Parameter", IEEE ACCESS, IEEE, USA, vol. 9, 4 March 2021 (2021-03-04), pages 40665 - 40680, XP011843974, DOI: 10.1109/ACCESS.2021.3063810

## Description

### Domaine technique

La présente divulgation relève du domaine des énergies renouvelables photovoltaïques et concerne un dispositif à cellules photovoltaïques multi jonctions autoréparables et un procédé d'autoréparation d'un tel dispositif permettant de réaliser une nouvelle architecture d'unité de génération solaire multi jonction. Dans le cas des cellules photovoltaïques multi jonction à base de couches mince, notamment de couches à base de matériaux pérovskite, ces couches peuvent présenter une dégradation réversible et donc peuvent permettre une autoréparation de ces couches et donc des cellules.

### Technique antérieure

Les cellules photovoltaïques silicium se dégradent de manière lente mais irréversible et leur durée de vie moyenne en production est de l'ordre de 40 ans (en considérant une dégradation de 0.5% par an et une fin de vie à 80% de la puissance nominale). Les nouvelles technologies de cellules pérovskite, qui vont être utilisées dans les modules multi jonctions pérovskite/silicium pour limiter la perte par thermalisation et ainsi augmenter le rendement, subissent selon les études en cours une dégradation plus importante qui varie selon les technologies étudiées (de l'ordre par exemple de 0,05% à 0,5% par jour). Toutefois une partie de cette dégradation, entre autres lié à la nature à la fois électronique et ionique des charges dans les matériaux pérovskites, est réversible ce qui permet d'envisager une autoréparation des couches pérovskite des cellules multi jonctions.

La dégradation réversible des couches pérovskite est notamment liée au déplacement d'ions dans la structure de ces couches. Contrairement au cas de référence du Silicium on observe en conditions réelle des phénomènes transitoires, par exemple sur les cycles jour-nuit et on peut tirer parti de ces phénomènes pour réduire la dégradation et retrouver des performances optimales des cellules. A ce jour, l'autoréparation, dans le cas de dégradation réversible, est limitée à la récupération lors des périodes nocturnes, cette récupération s'assimilant à un repos de la cellule.

Le document MIME FARHA ISLAM ET AL: "Design and Performance Analysis of Tandem Organic Solar Cells: Effect of Cell Parameter",IEEE ACCESS, IEEE, USA, vol. 9, 4 mars 2021 (2021-03-04), pages 40665-40680, décrit une cellule photovoltaïque multi jonctions comprenant un empilement de quatre sous-cellules à absorbeur pérovskite. Les bandes interdites des matériaux pérovskites diminuent entre la face avant et la face arrière de l'assemblage. Cette cellule photovoltaïque multi jonctions dispose de deux électrodes de connexion disposées respectivement en face avant et en face arrière de la cellule.

### Problème technique

L'autoréparation, qui est limitée à la durée des périodes nocturnes et qui n'est notamment pas contrôlée par algorithme, peut ne pas prendre en compte la totalité des besoins d'autoréparation créés par l'usage des cellules, n'est pas optimisée et ne permet pas notamment de rechercher et fournir un optimum de régénération nécessaire pour revenir au point initial de performance des cellules à chaque cycle/jour.

### Exposé de l'invention

Au vu de cette situation, l'objectif de la présente divulgation est d'une part de proposer des cellules permettant d'optimiser leur autoréparation et de réaliser des modules photovoltaïques pourvus de telles cellules et, d'autre part, de fournir des méthodes et algorithmes de pilotage de tels modules photovoltaïques pour piloter et maximiser l'autoréparation desdites cellules. Pour ce faire la présente invention se base sur des assemblages photovoltaïques configurés pour permettre l'utilisation de premiers empilement photovoltaïques en générateur électrique tandis qu'un second empilement photovoltaïque subit un processus d'autoréparation pendant la journée.

Plus précisément la présente divulgation propose un assemblage photovoltaïque tel que revendiqué dans la revendication indépendante 1, et comprenant depuis une première face de l'assemblage vers une deuxième face de l'assemblage :
- une première électrode de connexion d'une première couche transparente de contact électrique sur au moins une première couche d'extraction sélective de charges d'un premier empilement photovoltaïque,
- le premier empilement photovoltaïque,
- une deuxième électrode de connexion d'une seconde couche transparente de contact électrique sur au moins une seconde couche d'extraction sélective de charges dudit premier empilement photovoltaïque,
- une première couche isolante transparente,
- une troisième électrode de connexion d'une première couche transparente de contact électrique sur au moins une seconde couche d'extraction sélective de charges d'un deuxième empilement photovoltaïque,
- le deuxième empilement photovoltaïque,
- une quatrième électrode de connexion d'une seconde couche transparente de contact électrique sur au moins une première couche d'extraction sélective de charges dudit deuxième empilement photovoltaïque,
- une deuxième couche isolante transparente,
- une cinquième électrode de connexion d'une première couche transparente de contact électrique sur au moins une première couche d'extraction sélective de charges d'un troisième empilement photovoltaïque,
- le troisième empilement photovoltaïque,
- une sixième électrode de connexion d'une seconde couche transparente de contact électrique sur au moins une seconde couche d'extraction sélective de charges dudit troisième empilement photovoltaïque,
- une septième électrode de connexion d'une première couche transparente de contact électrique sur au moins une première couche d'extraction sélective de charges d'un quatrième empilement photovoltaïque,
- ledit quatrième empilement photovoltaïque,
- une huitième électrode de connexion d'une seconde couche transparente de contact électrique sur au moins une seconde couche d'extraction sélective de charges dudit quatrième empilement photovoltaïque,
ledit quatrième empilement photovoltaïque étant disposé entre le deuxième empilement photovoltaïque et le troisième empilement photovoltaïque, ledit quatrième empilement photovoltaïque étant un empilement à absorbeur d'un matériau de bande interdite inférieure à celle du troisième empilement, notamment absorbeur silicium, autre pérovskite, absorbeur couche mince ou autre matériau, lesdites électrodes dudit quatrième empilement étant indépendantes des électrodes des premier, deuxième et troisième empilements et pour lequel :
- le premier empilement photovoltaïque et le troisième empilement photovoltaïque sont des empilements photovoltaïques à absorbeur pérovskite,
- le deuxième empilement photovoltaïque est un empilement photovoltaïque à absorbeur d'un matériau de bande interdite inférieure à celle du premier empilement, notamment absorbeur silicium, autre pérovskite, absorbeur couche mince ou autre matériau,
- le quatrième empilement photovoltaïque est un empilement photovoltaïque à absorbeur d'un matériau de bande interdite inférieure à celle du troisième empilement, notamment absorbeur silicium, autre pérovskite, absorbeur couche mince ou autre matériau,
- lesdites électrodes de connexion desdites couches transparentes de contact électrique sont indépendantes les unes des autres.

Le premier et le troisième empilement photovoltaïque de l'assemblage peuvent comporter chacun :
- une ou plusieurs premières couches de protection et de passivation desdits absorbeurs entre lesdites premières couches d'extraction sélectives de charges électriques et ledit absorbeur pérovskite,
- ledit absorbeur de type pérovskite,
- une ou plusieurs deuxièmes couches de protection et de passivation desdits absorbeurs entre lesdites une ou plusieurs deuxièmes couches d'extraction sélective de charges électriques et ledit absorbeur de type pérovskite.

La présente divulgation propose en outre un dispositif photovoltaïque comportant un panneau pourvu d'assemblages photovoltaïques tels que décrits ci-dessus et comportant en outre un dispositif de raccordement électrique configuré pour :
- raccorder la première électrode et la troisième électrode, raccorder la deuxième électrode et la quatrième électrode desdits assemblages et former des premières cellules photovoltaïque bi-jonctions parallèles au moyen des premiers et deuxièmes assemblages sur un premier côté du panneau,
- raccorder la cinquième électrode et la septième électrode, raccorder la sixième électrode et la huitième électrode et former des secondes cellules photovoltaïque bi-jonctions parallèles au moyen des troisièmes et quatrièmes assemblages sur un second côté du panneau.

Le dispositif peut être tel que la première face du panneau étant disposée côté lumière solaire et la seconde face du panneau côté ombre, lesdites premières cellules photovoltaïques forment un premier générateur courant/tension, et lesdites secondes cellules photovoltaïques se trouvent dans un mode d'autoréparation et tel que le dispositif étant retourné avec la seconde face côté lumière solaire et la première face côté ombre, lesdites secondes cellules photovoltaïques forment un second générateur de tension/courant et lesdites premières cellules photovoltaïques se trouvent dans un mode d'autoréparation.

La présente divulgation propose en outre un système photovoltaïque comportant au moins :
- un dispositif photovoltaïque tel que décrit ci-dessus,
- un bâti muni de moyens de retournement du panneau,
- un module convertisseur à régulation MPPT et
- un module de régénération desdits absorbeurs pérovskite,
pour lequel le module convertisseur comporte des moyens de suivi d'une irradiance perçue par le panneau et des moyens de suivi de données météo, des moyens de suivi de la dégradation des absorbeurs de type par exemple pérovskite et des moyens de commande desdits moyens de retournement configurés pour retourner ledit panneau en cas de dégradation supérieure à un seuil défini de ceux desdits premier ou troisième empilements photovoltaïques à absorbeur pérovskite positionnés côté lumière solaire pour les positionner côté ombre et positionner les autres desdits premiers et troisièmes empilements photovoltaïques à absorbeur pérovskite côté lumière solaire, le dispositif de raccordement étant configuré pour déconnecter ceux desdits premiers et troisièmes empilement photovoltaïque positionnés côté ombre du module convertisseur et pour le connecter avec le module de régénération.

Le système peut être tel que le module de régénération comporte au moins l'un parmi :
- un dispositif de mise en court-circuit des électrodes d'un empilement photovoltaïque à absorbeur pérovskite qui lui est raccordé,
- un dispositif de mise en circuit ouvert des électrodes dudit empilement photovoltaïque à absorbeur pérovskite qui lui est raccordé,
- un dispositif générateur d'impulsions de tension vers l'empilement photovoltaïque à absorbeur pérovskite qui lui est raccordé,
et comporter des moyens de mesure courant/tension sous obscurité desdits empilements photovoltaïques à absorbeur pérovskite qui lui sont raccordés.

La présente divulgation propose aussi un procédé comportant une séquence de :
- une ou plusieurs mesures de l'irradiance perçue et de la température au niveau dudit au moins un panneau, et mesures des données météo ;
- une détection de la situation jour ou nuit ;
- si la nuit est détectée :
   - un ou plusieurs enregistrements et d'analyses de la régénération des premiers et troisièmes empilements photovoltaïques à absorbeur pérovskite, estimation du temps nécessaire à une régénération maximale desdits empilements et mise en œuvre de processus de régénération desdits premiers et troisièmes empilements photovoltaïques à absorbeur pérovskite dudit panneau (160);
- si le jour est détecté :
   - une ou plusieurs séquences comportant la régénération des empilements photovoltaïques à absorbeur pérovskite côté ombre (120), l'estimation des performances attendue des empilements photovoltaïques à absorbeur pérovskite côté lumière solaire, la mesure de la dégradation des empilements photovoltaïques à absorbeur pérovskite côté lumière solaire par rapport auxdites performances attendues et l'estimation du taux de régénération des empilements photovoltaïques à absorbeur pérovskite côté ombre dudit panneau par rapport auxdites performances attendues pour détecter un taux de régénération donnant une performance supérieure des empilements photovoltaïques à absorbeur côté ombre à une performance des empilements photovoltaïques à absorbeur pérovskite côté lumière solaire après dégradation et une détection telle que,
- si la régénération des empilements photovoltaïques à absorbeur pérovskite côté ombre correspond à une performance supérieure à une performance des empilements photovoltaïques à absorbeur pérovskite côté lumière solaire après dégradation, un retournement dudit panneau par commande desdits moyens de retournement ;
- si la régénération des empilements photovoltaïques à absorbeur pérovskite côté ombre reste inférieure à une performance des empilements photovoltaïques à absorbeur pérovskite côté lumière solaire dégradés, le maintien du panneau dans sa position.

Le procédé peut être tel que l'estimation du taux de régénération des empilements photovoltaïques à absorbeur pérovskite côté ombre dudit panneau comporte des mesures courant/tension dans l'ombre/à l'obscurité.

Les étapes de régénération peuvent comporter au moins une opération parmi :
- une ou plusieurs applications d'impulsions de tension aux bornes des empilements photovoltaïques à absorbeur pérovskite,
- une ou plusieurs mises en court-circuit desdits empilements photovoltaïques à absorbeur pérovskite et,
- une ou plusieurs mises en circuit ouvert desdits empilements photovoltaïques à absorbeur pérovskite

Ladite séquence peut être répétée durant le fonctionnement desdits panneaux.

Le système photovoltaïque comprend avantageusement un processeur associé à une mémoire programme contenant un programme pourvu d'instructions pour implémenter le procédé ci-dessus.

La présente divulgation prévoit en outre un support d'enregistrement non transitoire, lisible par un ordinateur, sur lequel est enregistré ledit programme.

### Brève description des dessins

D'autres caractéristiques, détails et avantages de l'invention apparaîtront à la lecture de la description détaillée ci-après d'exemples de réalisation non limitatifs, et à l'analyse des dessins annexés, sur lesquels :
[Fig. 1] montre une vue schématique en coupe transversale d'un assemblage photovoltaïque ;
[Fig. 2A], [Fig. 2B] montrent une vue schématique de mise en œuvre de l'assemblage de la figure 1 ;
[Fig. 3] montre un exemple de logigramme d'un procédé de pilotage de panneau photovoltaïque ;
[Fig. 4] montre une vue schématique de mise en œuvre d'un panneau pourvu de l'assemblage de nuit.

### Description de modes de réalisation

Les dessins et la description ci-après contiennent des éléments pouvant non seulement servir à mieux faire comprendre la présente invention, mais aussi contribuer à sa définition, le cas échéant.

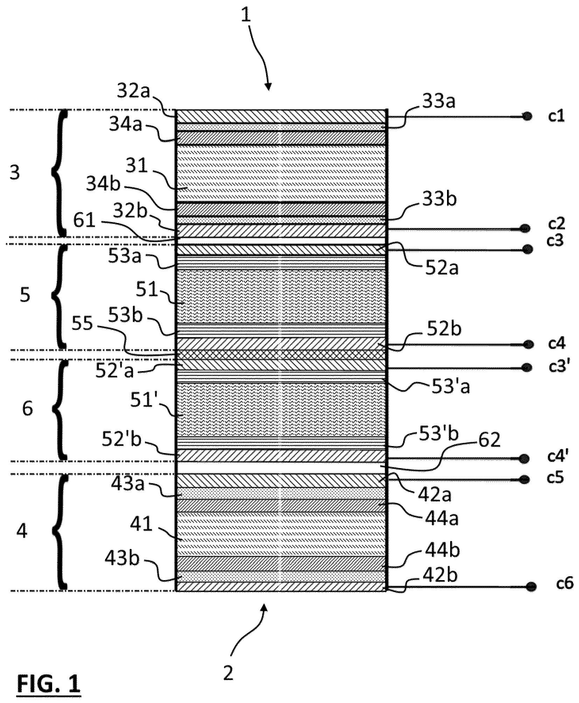

Il est maintenant fait référence à la figure 1 qui représente un assemblage photovoltaïque de la présente divulgation qui comprend depuis une première face 1 de l'assemblage vers une deuxième face 2 de l'assemblage :
- une première électrode c1 qui est reliée à une première couche de contact électrique transparente 32a, par exemple une grille de contact ou une couche conductrice, afin de connecter au moins une première couche transparente d'extraction de charges 33a d'un premier empilement photovoltaïque 3,
- le premier empilement photovoltaïque 3,
- une deuxième électrode c2 qui est reliée à une seconde couche de contact électrique transparente 32b, par exemple une grille de contact ou une couche conductrice, afin de connecter au moins une seconde couche transparente d'extraction de charges 33b dudit premier empilement photovoltaïque 3,
- une première couche isolante transparente 61,
- une troisième électrode c3 reliée à une première couche de contact électrique transparente 52a afin de connecter au moins une première couche transparente d'extraction de charges 53a d'un deuxième empilement photovoltaïque,
- le deuxième empilement photovoltaïque 5,
- une quatrième électrode c4 reliée à une seconde couche de contact électrique transparente 52b afin de connecter au moins une seconde couche transparente d'extraction de charges 53b dudit deuxième empilement photovoltaïque 5,
- une deuxième couche isolante transparente 62,
- une cinquième électrode c5 qui est reliée à une première couche de contact électrique transparente 42a afin de connecter au moins une première couche transparente d'extraction de charges 43a d'un troisième empilement photovoltaïque 4,
- le troisième empilement photovoltaïque 4,
- une sixième électrode c6 qui est reliée à une seconde couche de contact électrique transparente 42b afin de connecter au moins une seconde couche transparente d'extraction de charges 43b dudit troisième empilement photovoltaïque,
pour laquelle :
- le premier empilement photovoltaïque 3 et le troisième empilement photovoltaïque 4 sont des empilements photovoltaïques à absorbeur pérovskite 31, 41,
- le deuxième empilement photovoltaïque 5 est un empilement photovoltaïque à absorbeur silicium 51,
- lesdites électrodes c1, c2, c3, c4, c5, c6 de connexion desdites couches d'extraction 33a, 33b, 43a, 43b, 53a, 53b au travers desdites couches conductrices 32a, 32b, 42a, 42b, 52a, 52b sont indépendantes les unes des autres,
- l'assemblage comportant un quatrième empilement photovoltaïque 6 à absorbeur silicium entre le deuxième empilement photovoltaïque à absorbeur silicium 51' et le troisième empilement photovoltaïque 4 à absorbeur pérovskite 41. Ce quatrième empilement photovoltaïque 6 comportant ses propres électrodes c3' et c4'.

Dans cette configuration deux cellules multi jonctions, les assemblages formant les cellules 3 et 5 et les assemblages formant les cellules 4 et 6, sont dos à dos et sont utilisées alternativement par retournement du panneau les comportant. Ces deux assemblages sont séparés par une couche isolante électrique 55 qui peut être une couche transparente ou non.

Le premier empilement photovoltaïque et le troisième empilement photovoltaïque comportent chacun une ou plusieurs premières couches de protection et de passivation 34a, 44a, 33b, 44b desdits absorbeurs entre lesdites couches d'extraction sélectives 33a, 43a, 33b, 43b de charges électriques de chaque côté dudit absorbeur pérovskite 31, 41.

Les couches d'extraction sélective des charges peuvent notamment être des couches connues sous les abréviations ETL ou HTL (selon la dénomination anglaise « electron transport layer » ou « hole transport layer » soit couche de transport d'électrons ou couche de transport de trous en français).

Les couches isolantes électriquement et transparentes optiquement 61, 62 sont par exemple des couches connues dans le domaine selon l'acronyme EVA.

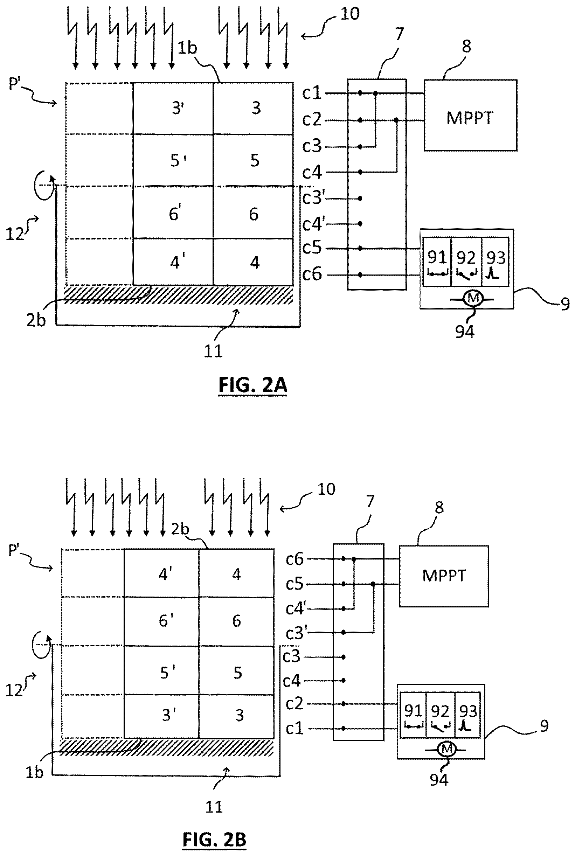

Les assemblages représentés sont des éléments constitutifs de panneaux photovoltaïques P schématisés à la figures 2A dans une première position et à la figure 2B en position retournée par rapport à la première position comme vu plus haut. Selon ces figures, deux séries d'assemblages sont représentées pour simplifier le dessin mais le panneau peut en comporter un grand nombre Selon une matrice x, y. Les assemblages sont choisis en fonction de la tension et courant souhaités en sortie du dispositif en fonctions du système électriques en aval. Dans le cadre de la présente divulgation, les électrodes des premiers empilements 3, 3' ... sont raccordées en parallèle, les électrodes des deuxièmes empilements 5, 5' ... sont raccordées en parallèle, les électrodes des troisièmes empilements 4, 4', ... sont raccordées en parallèle et les électrodes des empilages 6, 6', ... sont raccordées en parallèle.

Pour cette configuration, les empilements à absorbeur pérovskite qui se trouvent côté lumière 10 et les empilements à absorbeur silicium sous ces derniers reçoivent de la lumière et peuvent fonctionner en générateur tandis que les empilements à absorbeur silicium et les empilements à absorbeurs pérovskite qui se trouvent sous le panneau ne reçoivent pratiquement pas de lumière, les empilements à absorbeurs pérovskite sous le panneau pouvant être mis en configuration de régénération même durant la journée.

Pour ce faire un dispositif de raccordement 7 est configuré pour permettre de déconnecter les électrodes des empilements photovoltaïque à absorbeur pérovskite sous le panneau des électrodes des supérieurs qui sont connectées en parallèle. Ceci permet de connecter les électrodes des empilements à absorbeurs pérovskite sous le panneau à un module de régénération 9 tandis que les électrodes des empilements à absorbeurs pérovskite côté lumière 10 et les premiers empilements à absorbeurs silicium sont raccordés à un module convertisseur MPPT 8, MPPT étant l'acronyme de « Maximum power point tracking » en anglais soit « suivi du point maximal de puissance » en français.

Le dispositif de raccordement électrique peut comporter deux plaquettes porte contacts adaptées à tourner l'une par rapport à l'autre comme dans un connecteur rotatif ou peut être un dispositif électronique à interrupteurs électroniques par exemple à base de transistors de type IGBT (transistor bipolaire à grille isolée en français) ou MOSFET (Transistor à effet de champ à grille métal-oxyde en français) configurés pour distribuer les électrodes entre le module convertisseur MPPT 8 et le module de régénération 9 et asservis à la position du panneau.

Les assemblages du panneau sont tels qu'une première cellule multi jonction à base du premier empilement 3 à absorbeur pérovskite 31 et du premier empilement 5 à absorbeur silicium 51 et une seconde cellule multi jonction réalisée avec le second empilement 4 à absorbeur pérovskite 41 et le second empilement 6 à absorbeur silicium 51' sont réalisées. Selon la figure 2A ce sont les électrodes des seconds empilements photovoltaïques 4, 4' qui se trouvent sous le panneau dans l'ombre 11 du panneau lorsque la face 1a du panneau est côté lumière et que la face 2a du panneau se trouve côté ombre. Les électrodes de ces seconds empilements 4, 4' à absorbeurs pérovskite sont alors raccordés au travers du dispositif de raccordement électrique 7 au module de régénération tandis que selon le schéma représenté, les électrodes des seconds empilements 6, 6' sont laissées déconnectées. Dans ce cas, les premiers empilements 3, 3' à absorbeurs pérovskite côté lumière 11 et les empilements 5, 5' à absorbeurs silicium sont connectés ensemble et raccordés au module convertisseur MPPT 8 au travers du dispositif de raccordement électrique 7.

Lorsque le panneau est retourné selon la figure 2B, les premiers empilements 3, 3' à absorbeurs pérovskite se retrouvent sous le panneau côté ombre 11 et sont alors connectés au module de régénération 9 tandis que les premiers empilements à absorbeurs silicium 5, 5' sont déconnectés. Du côté lumière solaire 10 les seconds empilements à absorbeur pérovskite et les seconds empilements silicium 6, 6' sont connectés en parallèles et raccordés au module convertisseur MPPT 8.

Ce système permet donc de procéder à des séquences d'autoréparation ou de régénération des empilements à absorbeur pérovskite qui se trouvent sous le panneau pendant la journée alors que le panneau fournit de l'électricité au moyen des cellules multi jonctions formées par les empilements à absorbeur pérovskite et silicium côté lumière en face supérieure.

Pour permettre le fonctionnement des panneaux P, P' comme expliqué ci-dessus, ces derniers sont intégrés dans un système photovoltaïque comportant lesdits panneaux montés dans des bâtis muni de moyens 12 de retournement des panneaux, les dispositifs de raccordement électrique 7 associés aux panneaux, préférablement un par panneau ou un par groupe d'assemblages selon une répartition par rangée ou par colonne d'assemblages sur le panneau, un ou plusieurs module convertisseurs 8 à régulation MPPT et un ou plusieurs modules 9 de régénération desdits absorbeurs pérovskite.

Le ou les modules convertisseurs sont raccordés aux sorties panneaux de manière traditionnelle. Ces modules convertisseurs comportent préférablement des moyens de suivi d'une irradiance perçue par le panneau et des moyens de suivi de données météo.

Selon la présente divulgation les module convertisseurs ou des modules de surveillance qui leur sont associés sont pourvus de moyens de suivi de la dégradation des absorbeurs pérovskite 31, 41 et des moyens de commande desdits moyens de retournement 12 configurés pour retourner les panneaux qui leur sont associés en cas de dégradation supérieure à un seuil défini de ceux desdits empilements photovoltaïques 3, 4 à absorbeur pérovskite du panneau positionnés côté lumière solaire 10 pour les positionner côté ombre et positionner côté lumière solaire les empilements photovoltaïques à absorbeur pérovskite 4, 3 du panneau précédemment côté ombre.

En parallèle, lors des retournements, le dispositif de raccordement 7 des panneaux est configuré pour déconnecter ceux desdits premiers et troisièmes empilement photovoltaïque positionnés côté ombre du module convertisseur 8 et pour les connecter avec les modules de régénération 9 associés aux panneaux retournés.

Pour la régénération des absorbeurs pérovskite liée au déplacement d'ions et leur distribution, les modules de régénération comportent au moins l'un parmi un dispositif 91 de mise en court-circuit des électrodes d'un empilement photovoltaïque à absorbeur pérovskite qui lui est raccordé, un dispositif 92 de mise en circuit ouvert des électrodes dudit empilement photovoltaïque à absorbeur pérovskite qui lui est raccordé, un dispositif 93 générateur d'impulsions de tension vers l'empilement photovoltaïque à absorbeur pérovskite qui lui est raccordé.

Pour mesurer la dégradation et la régénération des empilements le module de régénération 9 comporte des moyens 94 de mesure courant/tension desdits empilements photovoltaïques à absorbeur pérovskite sous obscurité.

Ces dispositifs sont utilisés en fonction de la dégradation desdits empilements pour réaliser un repositionnement des ions selon des séquences déterminées comportant par exemple des modes de régénération comportant notamment une mise en court-circuit des empilements, une mise en circuit ouvert des empilements, une génération d'impulsions de tension aux bornes des empilements, le système étant configuré pour évaluer de façon autonome si le traitement est efficace ou passer à un autre mode.

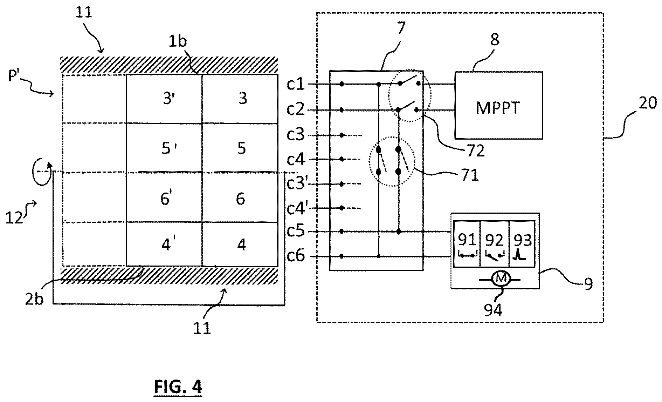

Il est à noter que le jour les empilements situés sous les panneaux sont régénérés tandis que la nuit les empilements à absorbeurs pérovskite des deux faces du panneau sont régénérés. Pour ce faire, le dispositif connecteur peut, comme représenté en figure 4, où les raccordements des assemblages 5 et 6 ne sont pas représentés pour simplifier, comporter deux groupes d'interrupteurs supplémentaires 71, 72 commandés par le module convertisseurs et les moyens de détection jour/nuit par exemple issus des moyens de suivi météo, ces groupes d'interrupteurs supplémentaires 71, 72 permettant de raccorder l'ensemble des empilements à absorbeur pérovskite au dispositif de régénération 9 et à les déconnecter du module convertisseur 8. Toujours selon la figure 4, le dispositif interrupteur 7, le module convertisseur 8 et le module de régénération sont regroupé dans un appareil de supervision ou de gestion de panneaux solaires 20.

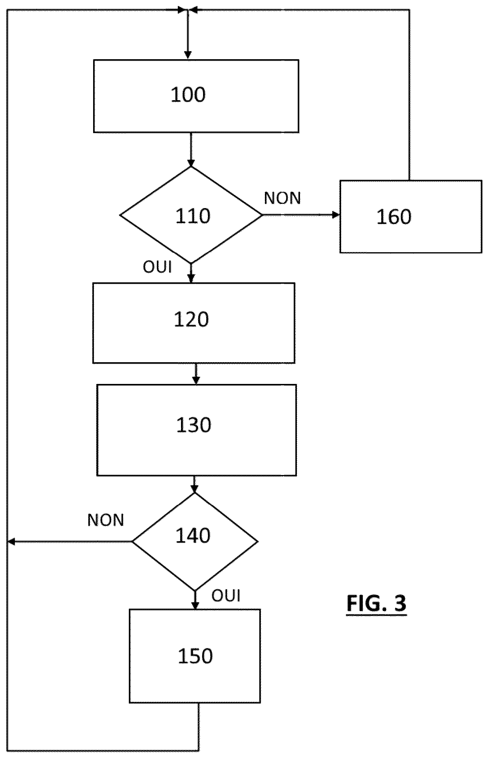

Un procédé de pilotage d'un système photovoltaïque tel que décrit en figure 3 peut notamment comporter une séquence de :
une ou plusieurs mesures de l'irradiance perçue et de la température au niveau dudit au moins un panneau, et mesures des données météo ;
une détection 110 de la situation jour ou nuit ;
si la nuit est détectée :
   - un ou plusieurs enregistrement et analyse de la régénération des premiers et troisièmes empilements photovoltaïques à absorbeur pérovskite, estimation du temps nécessaire à une régénération maximale desdits empilements et mise en œuvre de processus de régénération desdits empilements photovoltaïques à absorbeur pérovskite dudit panneau 160 ;
si le jour est détecté :
   - une ou plusieurs séquences comportant la régénération des empilements photovoltaïques à absorbeur pérovskite côté ombre 120, l'estimation des performances attendue des empilements photovoltaïques à absorbeur pérovskite côté lumière solaire, la mesure de la dégradation des empilements photovoltaïques à absorbeur pérovskite côté lumière solaire par rapport auxdites performances attendues et l'estimation du taux de régénération des empilements photovoltaïques à absorbeur pérovskite côté ombre dudit panneau par rapport auxdites performances attendues pour détecter un taux de régénération donnant une performance supérieure des empilements photovoltaïques à absorbeur côté ombre à une performance des empilements photovoltaïques à absorbeur pérovskite côté lumière solaire après dégradation 130 et une détection 140 telle que :
      - si la régénération des empilements photovoltaïques à absorbeur pérovskite côté ombre correspond à une performance supérieure à une performance des empilements photovoltaïques à absorbeur pérovskite côté lumière solaire après dégradation, un retournement 150 dudit panneau par commande desdits moyens de retournement 12 ;
      - si la régénération des empilements photovoltaïques à absorbeur pérovskite côté ombre reste inférieure à une performance des empilements photovoltaïques à absorbeur pérovskite côté lumière solaire dégradés, le maintien du panneau dans sa position.

L'estimation du taux de régénération des empilements photovoltaïques à absorbeur pérovskite côté ombre dudit panneau comporte des mesures courant/tension dans l'ombre.

Les étapes de régénération comportent au moins une opération parmi :
a. une ou plusieurs applications d'impulsions de tension aux bornes des empilements photovoltaïques à absorbeur pérovskite,
b. une ou plusieurs mises en court-circuit desdits empilements photovoltaïques à absorbeur pérovskite et,
c. une ou plusieurs mises en circuit ouvert desdits empilements photovoltaïques à absorbeur pérovskite.

Ladite séquence est notamment répétée durant le fonctionnement desdits panneaux et la vie du système.

L'invention ne se limite pas aux exemples décrits ci-avant, seulement à titre d'exemple, mais elle englobe toutes les variantes que pourra envisager l'homme de l'art dans le cadre de la protection recherchée. En particulier les module convertisseur dispositif connecteur et module de régénération peuvent être des éléments séparés ou regroupés dans un dispositif contrôleur par partie ou en totalité et le procédé peut être intégré dans un procédé de gestion de parc de panneaux photovoltaïques ou de groupes de panneaux.

## Revendications

1. - Assemblage photovoltaïque comprenant à partir d'une première face (1) de l'assemblage vers une couche isolante médiane (55) dudit assemblage:
- une première électrode (c1) de connexion d'une première couche transparente (32a) de contact électrique sur au moins une première couche d'extraction sélective de charges (33a) d'un premier empilement photovoltaïque (3),
- le premier empilement photovoltaïque (3),
- une deuxième électrode (c2) de connexion d'une seconde couche transparente (32b) de contact électrique sur au moins une seconde couche d'extraction sélective de charges (33b) dudit premier empilement photovoltaïque,
- une première couche isolante transparente (61),
- une troisième électrode (c3) de connexion d'une première couche transparente (52a) de contact électrique sur au moins une seconde couche d'extraction sélective de charges (53a) d'un deuxième empilement photovoltaïque (5),
- le deuxième empilement photovoltaïque (5),
- une quatrième électrode (c4) de connexion d'une seconde couche transparente (52b) de contact électrique sur au moins une première couche d'extraction sélective de charges (53b) dudit deuxième empilement photovoltaïque,
- ladite couche isolante médiane (55),
- à partir d'une seconde face (2) vers ladite couche isolante médiane (55),une sixième électrode (c6) de connexion d'une seconde couche transparente (42b) de contact électrique sur au moins une seconde couche d'extraction sélective de charges (43b) d'un troisième empilement photovoltaïque,
- le troisième empilement photovoltaïque (4),
- une cinquième électrode (c5) de connexion d'une première couche transparente (42a) de contact électrique sur au moins une première couche d'extraction sélective de charges (43a) dudit troisième empilement photovoltaïque (4),
- une huitième électrode (c4') de connexion d'une seconde couche transparente (52'b) de contact électrique sur au moins une seconde couche d'extraction sélective de charges (53'b) d'un quatrième empilement photovoltaïque (6),
- ledit quatrième empilement photovoltaïque (6),
- une septième électrode (c3') de connexion d'une première couche transparente (52'a) de contact électrique sur au moins une première couche d'extraction sélective de charges (53'a) dudit quatrième empilement photovoltaïque,
ledit quatrième empilement photovoltaïque (6) étant disposé entre le deuxième empilement photovoltaïque (5) et le troisième empilement photovoltaïque, lesdites électrodes dudit quatrième empilement photovoltaïque étant indépendantes des électrodes des premier, deuxième et troisième empilements photovoltaïques, et pour lequel :
- le premier empilement photovoltaïque (3) et le troisième empilement photovoltaïque (4) sont des empilements photovoltaïques à absorbeur pérovskite (31, 41),
- le deuxième empilement photovoltaïque est un empilement photovoltaïque à absorbeur (51) d'un matériau de bande interdite inférieure à celle du premier empilement photovoltaïque, notamment absorbeur silicium, autre pérovskite, absorbeur couche mince ou autre matériau,
- le quatrième empilement photovoltaïque est un empilement photovoltaïque à absorbeur (51) d'un matériau de bande interdite inférieure à celle du troisième empilement photovoltaïque, notamment absorbeur silicium, autre pérovskite, absorbeur couche mince ou autre matériau,
- lesdites électrodes (c1, c2, c3, c4, c5, c6, c3', c4') de connexion desdites couches transparentes de contact électrique (32a, 32b, 42a, 42b, 52a, 52b, 52'a, 52'b) sont indépendantes les unes des autres.

2. - Assemblage photovoltaïque selon la revendication 1 pour lequel le premier et le troisième empilement photovoltaïque comporte chacun :
- une ou plusieurs premières couches de protection et de passivation (34a, 44a) desdits absorbeurs entre lesdites premières couches d'extraction sélectives (33a, 43a) de charges électriques et ledit absorbeur pérovskite,
- ledit absorbeur (31, 41) de type pérovskite,
- une ou plusieurs deuxièmes couches de protection et de passivation (34b, 44b) dudit absorbeur de type pérovskite entre lesdites une ou plusieurs deuxièmes couches d'extraction sélective (43a, 43b) de charges électriques et ledit absorbeur de type pérovskite.

3. - Dispositif photovoltaïque comportant un panneau (P') pourvu d'assemblages photovoltaïques selon la revendication 1 ou 2 et comportant en outre un dispositif de raccordement électrique configuré pour :
- raccorder la première électrode (c1) et la troisième électrode (c3), raccorder la deuxième électrode (c2) et la quatrième électrode (c4) desdits assemblages et former des premières cellules photovoltaïque bi-jonctions parallèles au moyen des premiers et deuxièmes assemblages (3, 5) sur un premier côté (1a) du panneau (P'),
- raccorder la cinquième électrode (c5) et la septième électrode (c3'), raccorder la sixième électrode (c6) et la huitième électrode (c4') et former des secondes cellules photovoltaïque bi-jonctions parallèles au moyen des troisièmes et quatrièmes assemblages (4, 5') sur un second côté (2a) du panneau (P').

4. - Dispositif photovoltaïque selon la revendication 3 tel que la première face (1a) du panneau (P') étant disposée côté lumière solaire et la seconde face (2a) du panneau (P') côté ombre, lesdites premières cellules photovoltaïques forment un premier générateur courant/tension, et lesdites secondes cellules photovoltaïques se trouvent dans un mode d'autoréparation et tel que le dispositif étant retourné avec la seconde face côté lumière solaire et la première face côté ombre, lesdites secondes cellules photovoltaïques forment un second générateur de tension/courant et lesdites premières cellules photovoltaïques se trouvent dans un mode d'autoréparation.

5. - Système photovoltaïque comportant au moins :
- un dispositif photovoltaïque selon la revendication 3 ou 4,
- un bâti muni de moyens (12) de retournement du panneau (P),
- un module convertisseur (8) à régulation MPPT et
- un module (9) de régénération desdits absorbeurs pérovskite,
pour lequel le module convertisseur (8) comporte des moyens de suivi d'une irradiance perçue par le panneau et des moyens de suivi de données météo, des moyens de suivi de la dégradation des absorbeurs de type par exemple pérovskite (31, 41) et des moyens de commande desdits moyens de retournement (12) configurés pour retourner ledit panneau en cas de dégradation supérieure à un seuil défini de ceux desdits premier ou troisième empilements photovoltaïques (3, 4) à absorbeur pérovskite positionnés côté lumière solaire (10) pour les positionner côté ombre et positionner les autres desdits premiers et troisièmes empilements photovoltaïques à absorbeur pérovskite (4, 3) côté lumière solaire, le dispositif de raccordement (7) étant configuré pour déconnecter ceux desdits premiers et troisièmes empilement photovoltaïque positionnés côté ombre du module convertisseur (8) et pour le connecter avec le module de régénération (9).

6. - Système photovoltaïque selon la revendication 5 pour lequel le module de régénération (9) comporte au moins l'un parmi :
- un dispositif (91) de mise en court-circuit des électrodes d'un empilement photovoltaïque à absorbeur pérovskite qui lui est raccordé,
- un dispositif (92) de mise en circuit ouvert des électrodes dudit empilement photovoltaïque à absorbeur pérovskite qui lui est raccordé,
- un dispositif (93) générateur d'impulsions de tension vers l'empilement photovoltaïque à absorbeur pérovskite qui lui est raccordé,
- et comporte des moyens (94) de mesure courant/tension sous obscurité desdits empilements photovoltaïques à absorbeur pérovskite qui lui sont raccordés.

7. - Procédé de pilotage d'un système photovoltaïque selon la revendication 6 comportant une séquence de :
- une ou plusieurs mesures de l'irradiance perçue et de la température au niveau dudit au moins un panneau, et mesures des données météo ;
- une détection (110) de la situation jour ou nuit ;
a. si la nuit est détectée :
i. un ou plusieurs enregistrements et d'analyses de la régénération des premiers et troisièmes empilements photovoltaïques à absorbeur pérovskite, estimation du temps nécessaire à une régénération maximale desdits empilements et mise en œuvre de processus de régénération desdits premiers et troisièmes empilements photovoltaïques à absorbeur pérovskite dudit panneau (160);
b. si le jour est détecté :
i. une ou plusieurs séquences comportant la régénération des empilements photovoltaïques à absorbeur pérovskite côté ombre (120), l'estimation des performances attendue des empilements photovoltaïques à absorbeur pérovskite côté lumière solaire, la mesure de la dégradation des empilements photovoltaïques à absorbeur pérovskite côté lumière solaire par rapport auxdites performances attendues et l'estimation du taux de régénération des empilements photovoltaïques à absorbeur pérovskite côté ombre dudit panneau par rapport auxdites performances attendues pour détecter un taux de régénération donnant une performance supérieure des empilements photovoltaïques à absorbeur côté ombre à une performance des empilements photovoltaïques à absorbeur pérovskite côté lumière solaire après dégradation (130) et une détection (140) telle que,
ii. si la régénération des empilements photovoltaïques à absorbeur pérovskite côté ombre correspond à une performance supérieure à une performance des empilements photovoltaïques à absorbeur pérovskite côté lumière solaire après dégradation, un retournement (150) dudit panneau par commande desdits moyens de retournement (12);
iii. si la régénération des empilements photovoltaïques à absorbeur pérovskite côté ombre reste inférieure à une performance des empilements photovoltaïques à absorbeur pérovskite côté lumière solaire dégradés, le maintien du panneau dans sa position.

8. - Procédé de pilotage de panneaux selon la revendication 7 pour lequel l'estimation du taux de régénération des empilements photovoltaïques à absorbeur pérovskite côté ombre dudit panneau comporte des mesures courant/tension dans l'ombre/à l'obscurité.

9. - Procédé de pilotage de panneaux selon la revendication 7 ou 8 pour lequel les étapes de régénération comportent au moins une opération parmi :
a. une ou plusieurs applications d'impulsions de tension aux bornes des empilements photovoltaïques à absorbeur pérovskite,
b. une ou plusieurs mises en court-circuit desdits empilements photovoltaïques à absorbeur pérovskite et,
c. une ou plusieurs mises en circuit ouvert desdits empilements photovoltaïques à absorbeur pérovskite

10. - Procédé de pilotage de panneaux selon la revendication 7, 8 ou 9 pour lequel ladite séquence est répétée durant le fonctionnement desdits panneaux.

11. - Système photovoltaïque selon la revendication 5 ou 6 comprenant un processeur associé à une mémoire programme contenant un programme pourvu d'instructions pour implémenter le procédé de l'une quelconque des revendications 7 à 10.

12. - Support d'enregistrement non transitoire, lisible par un ordinateur, sur lequel est enregistré le programme de la revendication 11.

## Patentansprüche

1. Photovoltaik-Baugruppe, umfassend von einer ersten Seite (1) der Baugruppe zu einer mittleren Isolierschicht (55) der Baugruppe:
- eine erste Elektrode (c1) zum Verbinden einer ersten transparenten elektrischen Kontaktschicht (32a) auf wenigstens einer ersten Schicht zur selektiven Ladungsextraktion (33a) eines ersten photovoltaischen Stapels (3),
- den ersten photovoltaischen Stapel (3),
- eine zweite Elektrode (c2) zum Verbinden einer zweiten transparenten elektrischen Kontaktschicht (32b) auf wenigstens einer zweiten Schicht zur selektiven Ladungsextraktion (33b) des ersten photovoltaischen Stapels,
- eine erste transparente Isolierschicht (61),
- eine dritte Elektrode (c3) zum Verbinden einer ersten transparenten elektrischen Kontaktschicht (52a) auf wenigstens einer zweiten Schicht zur selektiven Ladungsextraktion (53a) eines zweiten photovoltaischen Stapels (5),
- den zweiten photovoltaischen Stapel (5),
- eine vierte Elektrode (c4) zum Verbinden einer zweiten transparenten elektrischen Kontaktschicht (52b) auf wenigstens einer ersten Schicht zur selektiven Ladungsextraktion (53b) des zweiten photovoltaischen Stapels,
- die mittlere Isolierschicht (55),
- von einer zweiten Seite (2) zu der mittleren Isolierschicht (55), eine sechste Elektrode (C6) zum Verbinden einer zweiten transparenten elektrischen Kontaktschicht (42b) auf wenigstens einer zweiten Schicht zur selektiven Ladungsextraktion (43b) eines dritten photovoltaischen Stapels,
- den dritten photovoltaischen Stapel (4),
- eine fünfte Elektrode (c5) zum Verbinden einer ersten transparenten elektrischen Kontaktschicht (42a) auf wenigstens einer ersten Schicht zur selektiven Ladungsextraktion (43a) des dritten photovoltaischen Stapels (4),
- eine achte Elektrode (c4') zum Verbinden einer zweiten transparenten elektrischen Kontaktschicht (52'b) mit wenigstens einer zweiten Schicht zur selektiven Ladungsextraktion (53'b) eines vierten photovoltaischen Stapels (6),
- den vierten photovoltaischen Stapel (6),
- eine siebte Elektrode (C3') zum Verbinden einer ersten transparenten elektrischen Kontaktschicht (52'a) mit wenigstens einer ersten Schicht zur selektiven Ladungsextraktion (53'a) des vierten photovoltaischen Stapels,
wobei der vierte photovoltaische Stapel (6) zwischen dem zweiten photovoltaischen Stapel (5) und dem dritten photovoltaischen Stapel angeordnet ist, wobei die Elektroden des vierten photovoltaischen Stapels unabhängig von den Elektroden des ersten, zweiten und dritten photovoltaischen Stapels sind, und wobei:
- der erste photovoltaische Stapel (4) und der dritte photovoltaische Stapel (4) photovoltaische Stapel mit Perowskit-Absorber sind,
- der zweite photovoltaische Stapel ein photovoltaischer Stapel mit Absorber (51) aus einem Material mit einer Energielücke ist, die kleiner ist als die des ersten photovoltaischen Stapels, insbesondere Siliziumabsorber, anderes Perowskit, Dünnschichtabsorber oder anderes Material,
- der vierte photovoltaische Stapel ein photovoltaischer Stapel mit Absorber (51) aus einem Material mit einer Energielücke ist, die kleiner ist als die des dritten photovoltaischen Stapels, insbesondere Siliziumabsorber, anderes Perowskit, Dünnschichtabsorber oder anderes Material,
- die Elektroden (c1, c2, c3, c4, c5, c6, c3', c4') zum Verbinden der transparenten elektrischen Kontaktschichten (32a, 32b, 42a, 42b, 52a, 52b, 52'a, 52'b) voneinander unabhängig sind.

2. Photovoltaik-Baugruppe nach Anspruch 1, wobei der erste und der dritte photovoltaische Stapel jeweils umfassen:
- eine oder mehrere erste Schutz- und Passivierungsschichten (34a, 44a) der Absorber zwischen den ersten selektiven Extraktionsschichten (33a, 43a) für elektrische Ladungen und dem Perowskit-Absorber,
- den Perowskit-Absorber (31, 41),
- eine oder mehrere zweite Schutz- und Passivierungsschichten (34b, 44b) des Perowskit-Absorbers zwischen der einen oder den mehreren zweiten Schichten zur selektiven Ladungsextraktion (43a, 43b) und dem Perowskit-Absorber.

3. Photovoltaikvorrichtung, umfassend ein Paneel (P'), das mit Photovoltaik-Baugruppen nach Anspruch 1 oder 2 ausgestattet ist und ferner eine elektrische Verbindungsvorrichtung umfasst, die dazu ausgebildet ist:
- die erste Elektrode (c1) und die dritte Elektrode (c3) zu verbinden, die zweite Elektrode (c2) und die vierte Elektrode (c4) der Baugruppen zu verbinden und erste parallele Doppelübergangs-Photovoltaikzellen mittels der ersten und zweiten Baugruppen (3, 5) auf einer ersten Seite (1a) des Paneels (P') zu bilden,
- die fünfte Elektrode (c5) und die siebte Elektrode (c3') zu verbinden, die sechste Elektrode (c6) und die achte Elektrode (c4') zu verbinden und mittels der dritten und vierten Anordnungen (4, 5') auf einer zweiten Seite (2a) des Paneels (P') zweite parallele Doppelübergang-Photovoltaikzellen zu bilden.

4. Photovoltaikvorrichtung nach Anspruch 3, wobei die erste Seite (1a) des Paneels (P') der Sonnenlichtseite und die zweite Seite (2a) des Paneels (P') der Schattenseite zugewandt ist, die ersten Photovoltaikzellen einen ersten Strom-/Spannungsgenerator bilden und die zweiten Photovoltaikzellen sich in einem Selbstreparaturmodus befinden, und wobei die Vorrichtung umgedreht wird, wobei die zweite Seite der Sonnenlichtseite und die erste Seite der Schattenseite zugewandt ist, wobei die zweiten Photovoltaikzellen einen zweiten Spannungs-/Stromgenerator bilden und sich die ersten Photovoltaikzellen in einem Selbstreparaturmodus befinden.

5. Photovoltaikanlage, wenigstens umfassend:
- eine Photovoltaikvorrichtung nach Anspruch 3 oder 4,
- einen Rahmen, der mit Mitteln (12) zum Umdrehen des Paneels (P) ausgestattet ist,
- ein Wandlermodul (8) mit MPPT-Regelung und
- ein Modul (9) zur Regenerierung der Perowskit-Absorber,
wobei das Wandlermodul (8) umfasst: Mittel zur Verfolgung der vom Paneel wahrgenommenen Sonneneinstrahlung und Mittel zur Verfolgung von Wetterdaten, Mittel zur Überwachung der Verschlechterung von Absorbern, beispielsweise vom Perowskit-Typ (31, 41), und Mittel zur Steuerung der Umdrehmittel (12), die dazu ausgebildet sind, das Paneel im Falle einer Verschlechterung über einem definierten Schwellenwert der ersten oder dritten photovoltaischen Stapel (3, 4) mit Perowskit-Absorber, die auf der Sonnenlichtseite (10) positioniert sind, umzudrehen, um sie auf die Schattenseite zu positionieren und die anderen der ersten und dritten photovoltaischen Stapel mit Perowskit-Absorber (4, 3) auf der Sonnenlichtseite zu positionieren, wobei die Verbindungsvorrichtung (7) dazu ausgebildet ist, die auf der Schattenseite positionierten ersten und dritten photovoltaischen Stapel vom Wandlermodul (8) zu trennen und mit dem Regenerationsmodul (9) zu verbinden.

6. Photovoltaikanlage nach Anspruch 5, wobei das Regenerationsmodul (9) wenigstens eines der folgenden Elemente umfasst:
- eine Vorrichtung (91) zum Kurzschließen der Elektroden eines daran angeschlossenen photovoltaischen Stapels mit Perowskit-Absorber,
- eine Vorrichtung (92) zum Öffnen des Stromkreises der Elektroden der daran angeschlossenen photovoltaischen Stapel mit Perowskit-Absorber,
- eine Vorrichtung (93) zum Erzeugen von Spannungsimpulsen für den daran angeschlossenen photovoltaischen Stapel mit Perowskit-Absorber,
- und Mittel (94) zum Messen von Strom/Spannung im Dunkeln der daran angeschlossenen photovoltaischen Stapel mit Perowskit-Absorber.

7. Verfahren zum Steuern einer Photovoltaikanlage nach Anspruch 6, das eine Abfolge von folgenden Schritten umfasst:
- eine oder mehrere Messungen der wahrgenommenen Bestrahlungsstärke und der Temperatur an dem wenigstens einen Paneel sowie Messungen der Wetterdaten;
- eine Erkennung (110) der Tages- oder Nachtsituation;
a. wenn die Nacht erkannt wird:
i. eine oder mehrere Aufzeichnungen und Analysen der Regeneration der ersten und dritten photovoltaischen Stapel mit Perowskit-Absorber, Schätzung der für eine maximale Regeneration der Stapel erforderlichen Zeit und Durchführung von Regenerationsprozessen der ersten und dritten photovoltaischen Stapel mit Perowskit-Absorber des Paneels (160);
b. wenn der Tag erkannt wird:
i. eine oder mehrere Sequenzen, die die Regeneration der Photovoltaikstapel mit Perowskit-Absorber auf der Schattenseite (120) umfassen, die Schätzung der erwarteten Leistung der photovoltaischen Stapel mit Perowskit-Absorber auf der Sonnenlichtseite, die Messung der Verschlechterung der photovoltaischen Stapel mit Perowskit-Absorber auf der Sonnenlichtseite im Vergleich zu der erwarteten Leistung und die Schätzung der Regenerationsrate der photovoltaischen Stapel mit Perowskit-Absorber auf der Schattenseite des Paneels im Vergleich zu der erwarteten Leistung, um eine Regenerationsrate zu ermitteln, die eine höhere Leistung der photovoltaischen Stapel mit Absorber auf der Schattenseite als die Leistung der photovoltaischen Stapel mit Perowskit-Absorber auf der Sonnenlichtseite nach der Verschlechterung (130) ergibt und eine Erkennung (140) wie folgt
ii. wenn die Regeneration der photovoltaischen Stapel mit Perowskit-Absorber auf der Schattenseite einer höheren Leistung als die Leistung der photovoltaischen Stapel mit Perowskit-Absorber auf der Sonnenlichtseite nach einer Verschlechterung entspricht, ein Umdrehen (150) des Paneels durch Steuerung der Umdrehungsmittel (12);
iii. wenn die Regeneration der photovoltaischen Stapel mit Perowskit-Absorber auf der Schattenseite geringer bleibt als die Leistung der photovoltaischen Stapel mit Perowskit-Absorber auf der Sonnenlichtseite nach der Verschlechterung, ein Beibehalten des Paneels in seiner Position.

8. Verfahren zur Steuerung von Paneelen nach Anspruch 7, wobei die Schätzung der Regenerationsrate der photovoltaischen Stapel mit Perowskit-Absorber auf der Schattenseite des Paneels Strom-/Spannungsmessungen im Schatten/in der Dunkelheit umfasst.

9. Verfahren zur Steuerung von Modulen nach Anspruch 7 oder 8, wobei die Regenerierungsschritte wenigstens einen der folgenden Vorgänge umfassen:
a. ein- oder mehrfaches Anlegen von Spannungsimpulsen an die Klemmen der photovoltaischen Stapel mit Perowskit-Absorber,
b. ein- oder mehrfaches Kurzschließen der photovoltaischen Stapel mit Perowskit-Absorber und
c. ein- oder mehrfaches Einschalten der photovoltaischen Stapel mit Perowskit-Absorber.

10. Verfahren zum Steuern von Paneelen nach Anspruch 7, 8 oder 9, wobei die Sequenz während des Betriebs der Paneele wiederholt wird.

11. Photovoltaikanlage nach Anspruch 5 oder 6, umfassend einen Prozessor, der mit einem Programmspeicher verbunden ist, der ein Programm mit Anweisungen zur Umsetzung des Verfahrens nach einem der Ansprüche 7 bis 10 enthält.

12. Nichtflüchtiger, computerlesbarer Speicher, auf dem das Programm nach Anspruch 11 gespeichert ist.

## Claims

1. - Photovoltaic assembly comprising, from a first face (1) of the assembly to a middle insulating layer (55) of the assembly:
- a first electrode (c1) for connecting a first transparent electrical contact layer (32a) to at least a first selective charge extraction layer (33a) of a first photovoltaic stack (3),
- the first photovoltaic stack (3),
- a second electrode (c2) for connecting a second transparent electrical contact layer (32b) to at least a second selective charge extraction layer (33b) of said first photovoltaic stack,
- a first transparent insulating layer (61),
- a third electrode (c3) for connecting a first transparent electrical contact layer (52a) to at least a second selective charge extraction layer (53a) of a second photovoltaic stack (5),
- the second photovoltaic stack (5),
- a fourth electrode (c4) for connecting a second transparent electrical contact layer (52b) to at least a first selective charge extraction layer (53b) of said second photovoltaic stack,
- said middle insulating layer( 55),
- from a second face (2) towards said middle insulating layer (55), a sixth electrode (c6) for connecting a second transparent electrical contact layer (42b) to at least a second selective charge extraction layer (43b) of a third photovoltaic stack,
- the third photovoltaic stack (4),
- a fifth electrode (c5) for connecting a second transparent electrical contact layer (42b) to at least a second selective charge extraction layer (43b) of said third photovoltaic stack,
- an eighth electrode (c4') for connecting a second transparent electrical contact layer (52'b) to at least a second selective charge extraction layer (53'b) of a fourth photovoltaic stack (6),
- said fourth photovoltaic stack (6)
- a seventh electrode (c3') for connecting a first transparent electrical contact layer (52'a) to at least a first selective charge extraction layer (53'a) of said fourth photovoltaic stack,
said fourth photovoltaic stack (6) being arranged between the second photovoltaic stack (5) and the third photovoltaic stack, said electrodes of said fourth photovoltaic stack being independent from the electrodes of said first, second and third photovoltaic stacks, and wherein:
- the first photovoltaic stack (3) and the third photovoltaic stack (4) are photovoltaic stacks with perovskite absorber (31, 41),
- the second photovoltaic stack is a photovoltaic stack in which the absorber (51) material has a lower band gap than that of the first stack, in particular an absorber of silicon, another perovskite, a thin-film absorber, or some other material,
- the fourth photovoltaic stack is a photovoltaic stack in which the absorber (51) material has a lower band gap than that of the third stack, in particular an absorber of silicon, another perovskite, a thin-film absorber, or some other material,
- said electrodes (c1, c2, c3, c4, c5, c6, c3', c4') connecting said transparent electrical contact layers (32a, 32b, 42a, 42b, 52a, 52b, 52'a, 52'b) are independent of each other.

2. - Photovoltaic assembly according to claim 1, wherein the first and third photovoltaic stack each comprises:
- one or more first protection and passivation layers (34a, 44a) for said absorbers, between said first selective charge extraction layers (33a, 43a) and said perovskite absorber,
- said perovskite type of absorber (31, 41),
- one or more second protection and passivation layers (34b, 44b) for said absorbers, between said one or more second selective charge extraction layers (43a, 43b) and said perovskite type of absorber.

3. - Photovoltaic device comprising a panel (P') provided with photovoltaic assemblies according to claim 1 or 2 and further comprising an electrical connection device configured for:
- connecting the first electrode (c1) and the third electrode (c3), and connecting the second electrode (c2) and the fourth electrode (c4), of said assemblies and forming first parallel bi-junction solar cells by means of the first and second assemblies (3, 5) on a first side (1a) of the panel (P'),
- connecting the fifth electrode (c5) and the seventh electrode (c3'), connecting the sixth electrode (c6) and the eighth electrode (c4'), and forming second parallel bi-junction solar cells by means of the third and fourth assemblies (4, 5') on a second side (2a) of the panel (P').

4. - Photovoltaic device according to claim 3, such that, when the first face (1a) of the panel (P') is arranged on the sunlight side and the second face (2a) of the panel (P') on the shadow side, said first solar cells form a first current/voltage generator and said second solar cells are in a self-repair mode, and such that, when the device is turned over with the second face on the sunlight side and the first face on the shadow side, said second solar cells form a second voltage/current generator and said first solar cells are in a self-repair mode.

5. - Photovoltaic system comprising at least:
- a photovoltaic device according to claim 3 or 4,
- a frame provided with turning means (12) for turning the panel (P),
- a converter module (8) with MPPT regulation, and
- a regeneration module (9) for regenerating said perovskite absorbers,
wherein the converter module (8) comprises means for monitoring the irradiance detected by the panel and means for monitoring weather data, means for monitoring the degradation of the absorbers, for example perovskite type absorbers (31, 41), and means for controlling said turning means (12) which are configured to turn said panel over in the event of a degradation exceeding a defined threshold in those among said first or third photovoltaic stacks (3, 4) with perovskite absorber that are positioned on the sunlight side (10) in order to position them on the shadow side and to position the others among said first and third photovoltaic stacks with perovskite absorber (4, 3) on the sunlight side, the connection device (7) being configured to disconnect those among said first and third photovoltaic stacks that are positioned on the shadow side of the converter module (8) and to connect it to the regeneration module (9).

6. - Photovoltaic system according to claim 5, wherein the regeneration module (9) comprises at least one of:
- a device (91) for short-circuiting the electrodes of a photovoltaic stack with perovskite absorber that is connected to it,
- a device (92) for open-circuiting the electrodes of said photovoltaic stack with perovskite absorber that is connected to it,
- a device (93) for generating voltage pulses towards the photovoltaic stack with perovskite absorber that is connected to it,
- and comprises means (94) for measuring the current/voltage, in darkness, of said photovoltaic stacks with perovskite absorber that are connected to it.

7. - Method for controlling a photovoltaic system according to claim 6, comprising a sequence of:
- one or more measurements of the detected irradiance and the temperature at said at least one panel, and measurements of weather data;
- a detection (110) of whether it is a day or night situation;
a. if night is detected:
i. one or more recordings and analyses of the regeneration of the first and third photovoltaic stacks with perovskite absorber, estimation of the time required for maximum regeneration of said stacks, and implementation of regeneration processes for said first and third photovoltaic stacks with perovskite absorber of said panel (160);
b. if day is detected:
i. one or more sequences comprising: regeneration (120) of the shadow-side photovoltaic stacks with perovskite absorber; estimation of the expected performances of the sunlight-side absorber photovoltaic stacks with perovskite absorber; measurement of the degradation of the sunlight-side photovoltaic stacks with perovskite absorber relative to said expected performances; and estimation of the regeneration rate of the shadow-side photovoltaic stacks with perovskite absorber of said panel relative to said expected performances in order to detect a regeneration rate giving a higher performance of the shadow-side photovoltaic stacks with absorber than the performance of the sunlight-side photovoltaic stacks with perovskite absorber after degradation (130); and a detection (140) such that:
ii. if the regeneration of the shadow-side photovoltaic stacks with perovskite absorber corresponds to a higher performance than the performance of the sunlight-side photovoltaic stacks with perovskite absorber after degradation, said panel is turned over (150) by controlling said turning means (12);
iii. if the regeneration of the shadow-side photovoltaic stacks with perovskite absorber remains lower than the performance of the degraded sunlight-side photovoltaic stacks with perovskite absorber, the panel is maintained in its position.

8. - Method for controlling panels according to claim 7, wherein the estimation of the regeneration rate of the shadow-side photovoltaic stacks with perovskite absorber of said panel comprises current/voltage measurements in shadow/in darkness.

9. - Method for controlling panels according to claim 7 or 8, wherein the regeneration steps comprise at least one of the following operations:
a. one or more applications of voltage pulses across the photovoltaic stacks with perovskite absorber,
b. short-circuiting said photovoltaic stacks with perovskite absorber, one or more times, and
c. open-circuiting said photovoltaic stacks with perovskite absorber, one or more times.

10. - Method for controlling panels according to claim 7, 8, or 9, wherein said sequence is repeated throughout the operation of said panels.

11. - Photovoltaic system according to claim 5 or 6, comprising a processor associated with a program memory containing a program provided with instructions for implementing the method of any one of claims 7 to 10.

12. - Computer-readable non-transitory storage medium on which the program of claim 11 is stored.
